# EUROPEAN PATENT SPECIFICATION

(11) **EP 3 406 919 B1**
(45) Date of publication and mention of the grant of the patent: **27.01.2021**
(21) Application number: 17177278.3
(22) Date of filing: 22.06.2017
(51) Int. Cl.: F16B 19/10, H05K 7/14

(54) **LATCH AND ASSEMBLY USING THE SAME**
VERRIEGELUNG UND ANORDNUNG DAMIT
VERROU ET ENSEMBLE L'UTILISANT

(30) Priority: 22.05.2017 TW 106116888
(43) Date of publication of application: 28.11.2018
(73) Proprietor: Giga-Byte Technology Co., Ltd., New Taipei City 231 (TW)
(72) Inventor: CHANG, Shih-Ho, New Taipei City (TW); KAO, Yung-Shun, New Taipei City (TW)
(74) Representative: Grünecker Patent- und Rechtsanwälte PartG mbB

(56) References cited:
- JP-A- 2014 190 411
- JP-U- H0 198 910
- US-A- 4 970 761
- US-A1- 2016 348 707

## Description

### Technical Field

The disclosure relates to a latch and an assembly using the same, more particularly to a bidirectional latch and an assembly using the same.

### Background

The more efficient the processing unit of the electronic device is, more heat is produced, and therefore the demand of heat dissipation increases. Hence, a heat dissipating device is provided to remove the heat. Generally, the heat dissipating device is disposed on the processing unit through screws and elastic members, such as springs, to secure the heat dissipating device to an electronic board having the processing unit.

However, the elasticity of the elastic member cannot firmly fix the heat dissipating device to the electronic board. Therefore, when the electronic device is vibrated and hit, the heat dissipating device against the elastic member may shake with respect to the electronic board. As a result, the shaking or vibrating heat dissipating device may hit the processing unit and damage it.

JP 2014 190411 A discloses a clip for fixing several members.

### SUMMARY

The present disclosure provides a latch and an assembly using the same in order to firmly fix one object to another so as to prevent the aforementioned damage issue. The invention provides a latch and assembly as specified in the independent claims.

One embodiment of the disclosure provides a latch comprising a hollow pillar and a bolt. The hollow pillar includes a first engaging portion and a second engaging portion opposite to each other. The hollow pillar has an inserting hole. The inserting hole passes through the first engaging portion and the second engaging portion. The bolt is inserted into the inserting hole and is movable between a first inserting position and a second inserting position. When the bolt is moved from the first inserting position to the second inserting position along a direction from the first engaging portion pointing to the second engaging portion, and the second engaging portion is expanded by the bolt. Therefore, the outer edge of the second engaging portion is smaller when the second engaging portion is located at the first inserting position than is located at the second inserting position.

One embodiment of the disclosure provides an assembly comprising a first object and a second object. The second object has a through hole. The latch includes a hollow pillar and a bolt. The hollow pillar includes a first engaging portion and a second engaging portion opposite to each other. The hollow pillar has an inserting hole. The inserting hole passes through the first engaging portion and the second engaging portion. The first engaging portion is disposed through the through hole. The bolt is inserted into the inserting hole and is movable between a first inserting position and a second inserting position. When the bolt is moved from the first inserting position to the second inserting position, the second engaging portion is expanded by the bolt to make the size of the second engaging portion become larger.

According to the latch of the embodiment of the disclosure, the first object and the second object are respectively fixed to the first engaging portion and the second engaging portion of the hollow pillar, so the second object is immovable with respect to the first object, thereby the first object and components thereon are prevented from being damaged by the second object.

Moreover, the latch and the second object are assembled to be an assembly through the first engaging portion. When the bolt is moved to the second inserting position, the second engaging portion is expanded by the bolt. In other words, the size of the second engaging portion becomes larger when the bolt is moved from the first inserting position to the second inserting position. Thus, the second engaging portion of the latch is able to be disposed on the first object easily when the bolt is at the first inserting position, and is able to be fixed to the first object when the blot is at the second inserting position.

### BRIEF DESCRIPTION OF THE DRAWINGS

The present disclosure will become more fully understood from the detailed description given here in below and the accompanying drawings which are given by way of illustration only and thus are not intending to limit the present disclosure and wherein:
FIG. 1 is a perspective view of an assembly disposed on a first object;
FIG. 2 is a perspective view of the assembly in FIG. 1;
FIG. 3 is an exploded view of the assembly in FIG. 2;
FIG. 4 is an exploded side view of the assembly in FIG. 2;
FIGS. 5-6 are side views of an assembling process of the assembly in FIG. 2;
FIGS. 7-8 are side views of a process of assembling the assembly to the first object in FIG. 6;
FIG. 9 is a side view of an assembly in accordance with an embodiment of the invention; and
FIG. 10 is a perspective view of the assembly in FIG. 9 being disposed on the first object.

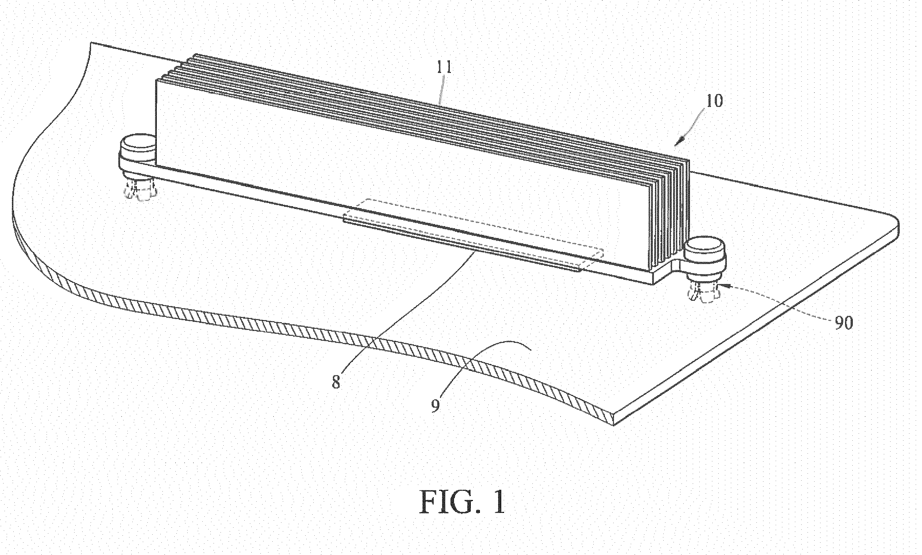

The latch as shown in figures 1-8 does not fall under the scope of claim 1.

### DETAILED DESCRIPTION

In the following detailed description, for purposes of explanation, numerous specific details are set forth in order to provide a thorough understanding of the disclosed examples and embodiments. It will be apparent, however, that one or more examples and embodiments may be practiced without these specific details. In other instances, well-known structures and devices are schematically shown in order to simplify the drawing.

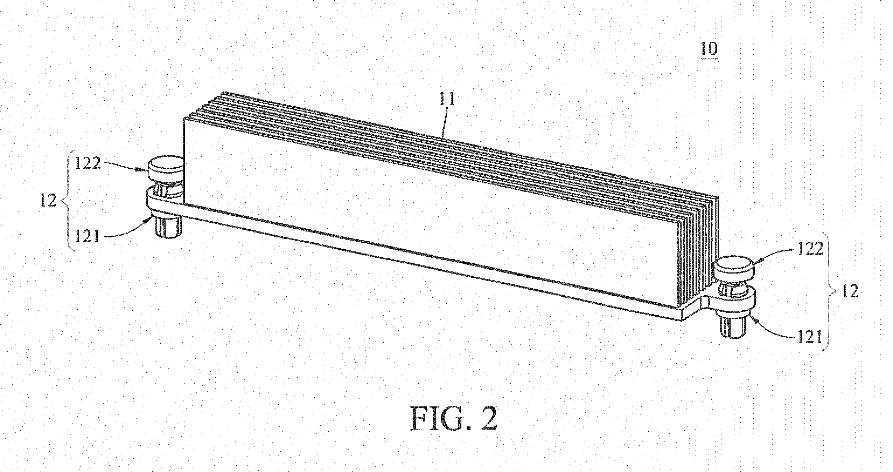

Please refer to FIG. 1 and FIG. 2. FIG. 1 is a perspective view of an assembly disposed on a first object in accordance with one example. FIG. 2 is a perspective view of the assembly in FIG. 1. In this example, the assembly 10 is able to be disposed on a first object 9 having a first through hole 90. The assembly 10 includes a second object 11 and a latch 12. A clamped member 8 can be disposed between the second object 11 and the first object 9. The latch 12 includes a hollow pillar 121 and a bolt 122. The second object 11 is able to be fixed to the first object 9 by applying the hollow pillar 121 of the latch 12 and the bolt 122. In this example, the first object 9 is, for example, a circuit board, and the second object 11, is for example, a heat dissipating component. The clamped member 8 is, for example, a processing unit. However, the present disclosure is not limited thereto. In some examples, the first object 9 may be a dissipating component, the second object 11 may be a circuit board, and the clamped member 8 may be a chip, a heat conductive member, a heat conductive adhesive or an assembly thereof.

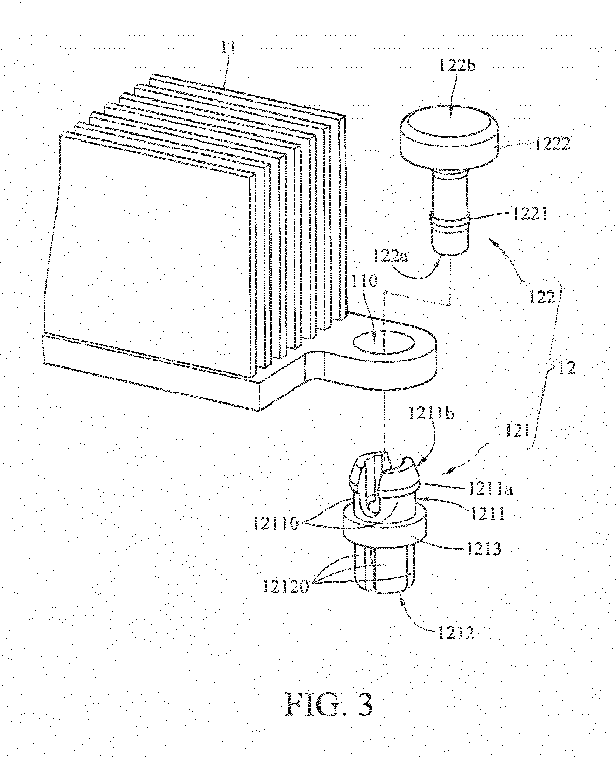

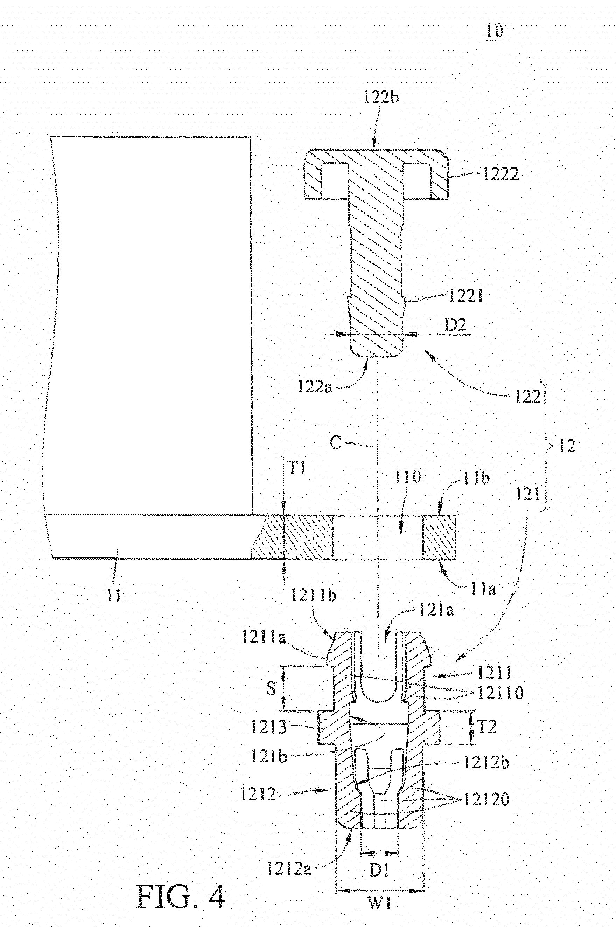

Please refer to FIG. 3 and FIG. 4. FIG. 3 is an exploded view of the assembly in FIG. 2. FIG. 4 is an exploded side view of the assembly in FIG. 2. The second object 11 has a second through hole 110.

The hollow pillar 121 of the latch 12 includes a first engaging portion 1211, a second engaging portion 1212, and a bearing block 1213. The first engaging portion 1211 and the second engaging portion 1212 are respectively located at two opposite sides of the bearing block 1213. The hollow pillar 121 has an inserting hole 121a, and the inserting hole 121a passes through the first engaging portion 1211, the second engaging portion 1212 and the bearing block 1213. The hollow pillar 121 has a positioning recess 121b at a side close to the inserting hole 121a.

The first engaging portion 1211 includes two engaging members 12110 spaced apart from each other. The engaging members 12110 surround the central axis C of the inserting hole 121a. Each engaging member 12110 has an engaging block 1211a at a side away from the inserting hole 121a. Each engaging block 1211a has a first guiding surface 1211b at a side away from the inserting hole 121a. The first guiding surface 1211b inclines toward the central axis C of the inserting hole 121a along a direction from the second engaging portion 1212 pointing to the first engaging portion 1211. Thus, when the first engaging portion 1211 is being inserted into the second through hole 110 along a direction from the bottom surface 11a of the second object 11 to the top surface 11b of the second object 11, the second object 11 is able to push the engaging block 1211a along the first guiding surface 1211b in order to move the engaging members 12110 to come closer to each other, and so that the engaging member 12110 is able to pass through the second through hole 110. When the engaging block 1211a passes through the second through hole 110, the engaging member 12110 recover to its original shape so as to be fixed to the second object 11.

In this example, although the first engaging portion 1211 includes two engaging members 12110, the present disclosure is not limited thereto. In other examples, the first engaging portion 1211 may have more than two engaging members 12110.

The second engaging portion 1212 includes four flexible arms 12120 spaced apart from one another. The flexible arms 12120 surround the central axis C of the inserting hole 121a. Each flexible arm 12120 has a pushing block 1212a at a side close to the inserting hole 121a. Each pushing block 1212a has a second guiding surface 1212b at a side close to the inserting hole 121a. The second guiding surface 1212b inclines toward the central axis C of the inserting hole 121a along a direction from the first engaging portion 1211 pointing to the second engaging portion 1212. The pushing blocks 1212a surround an area having an inner diameter D1. In this example, the number of the flexible arms 12120 is four, but the present disclosure is not limited thereto. In other examples, the number of the flexible arms 12120 may be adjusted.

There is a distance S between the bearing block 1213 and the engaging block 1211a, the distance S is determined by the thickness T1 of the second object 11, which is the distance between the bottom surface 11a and the top surface 11b of the second object 11. The thickness of the bearing block 1213 is determined by the thickness T3, which is the distance between the bottom surface 11a of the second object 11 and the first object 9.

The bolt 122 has a first end 122a and a second end 122b opposite to each other. When the bolt 122 is inserted into the inserting hole 121a of the hollow pillar 121 along a direction form the first engaging portion 1211 of the hollow pillar 121 pointing to the second engaging portion 1212 of the hollow pillar 121, the first end 122a of the bolt 122 is movable in the inserting hole 121a, and the second end 122b is movable outside the inserting hole 121a. The bolt 122 has a positioning protrusion 1221 between the first end 122a and the second end 122b. The first end 122a of the bolt 122 has an outer diameter D2, and the outer diameter D2 is larger than the inner diameter D1 of the pushing blocks 1212a. In this example, the bolt 122 has one positioning protrusion 1221, but the present disclosure is not limited thereto. In other examples, the bolt 122 may have more than one positioning protrusions 1221.

Furthermore, in this example, the second end 122b of the bolt 122 has a head portion 1222.

The bolt 122 is movable respect to the hollow pillar 121 so as to be moved between a first inserting position and a second inserting position. When the bolt 122 is at the first inserting position, the positioning protrusion 1221 of the bolt 122 is able to be located in positioning recess 121b of the hollow pillar 121. When the bolt 122 is moved from the first inserting position to the second inserting position along the direction from the first engaging portion 1211 pointing to the second engaging portion 1212, the positioning protrusion 1221 is able to be removed from the positioning recess 121b, and the first end 122a of the bolt 122 is able to force the flexible arms 1211a of the second engaging portions 1212 to deform and move outward along the second guiding surface 1212b of pushing block 1212a. In other words, when the bolt 122 is at the first inserting position, the second engaging portion 1212 has a first outer diameter W1 when the bolt 122 is at the first inserting portion, and has a second outer diameter W2 which is greater than the first outer diameter W1 when the bolt 122 is at the second inserting position. That is, the size of the second engaging portion 1212 becomes larger when the bolt 122 is moved from the first inserting position to the second inserting position.

Furthermore, when the bolt 122 is at the second inserting position, the head portion 1222 of the bolt 122 covers at least part of the first engaging portion 1211 of the hollow pillar 121 to make the appearance simple.

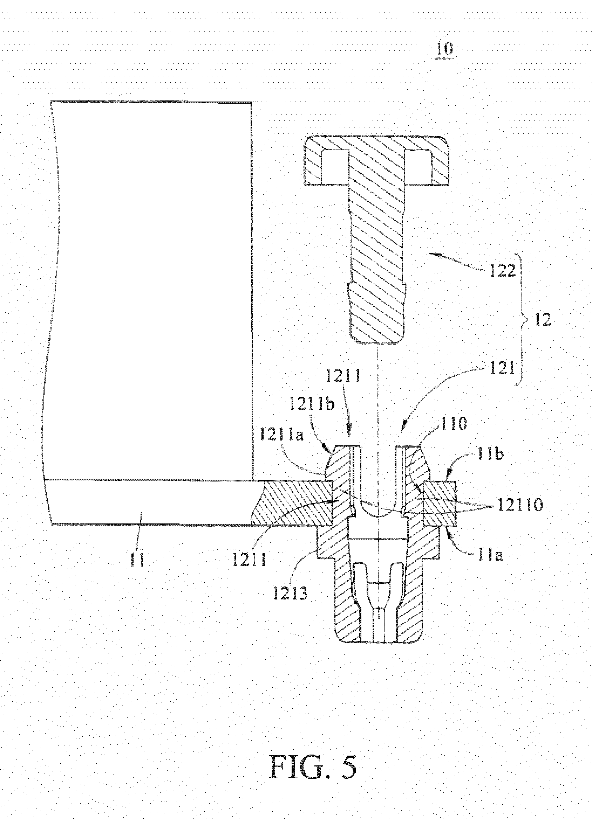

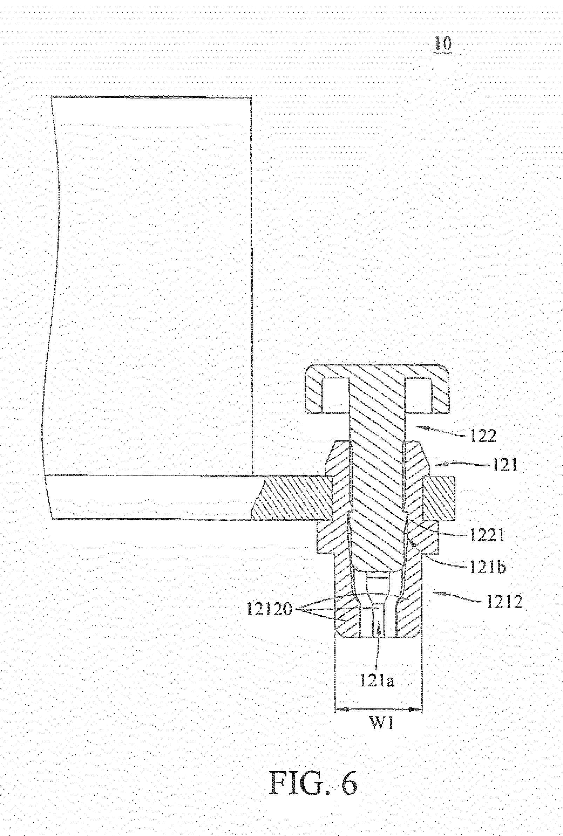

Please refer to FIG. 5 and FIG. 6. FIGS. 5-6 are side views of an assembling process of the assembly in FIG. 2. As shown in FIG. 5, firstly, the first engaging portion 1211 of the hollow pillar 121 is fixed to the second through hole 110 of the second object 11 to dispose the latch 12 to the second object 11. In detail, the engaging member 12110 of the first engaging portion 1211 is inserted into the second through hole 110 from the bottom surface 11a of the second object 11 to the top surface 11b of the second object 11. While the first engaging portion 1211 is being inserted into the second through hole 110, the second object 11 pushes the engaging block 1211a of the engaging member 12110 inward along the first guiding surface 1211b to make the engaging members 12110 to come closer to each other, so that the engaging block 1211a is able to pass through the second through hole 110. When the bearing block 1213 is in contact with the bottom surface 11a of the second object 11, the engaging members 12110 recover to its original shape so that the engaging blocks 1211a is fixed to the second object 11. When the engaging blocks 1211a is fixed to the second object 11, the second object 11 and the first engaging portion 1211 are located at the same side of the bearing block 1213, and the second object 11 is located between the engaging block 1211a and the bearing block 1213. Thus, the second object 11 and the hollow pillar 121 are firmly fixed in place.

Then, as shown in FIG. 6, the bolt 122 is inserted into the inserting hole 121a of the hollow pillar 121 to move to the first inserting position. When the bolt 122 is at the first inserting position, the positioning protrusion 1221 of the bolt 122 is located in the positioning recess 121b of the hollow pillar 121, and the assembling process of the assembly 10 is completed. Since the positioning protrusion 1221 is located in the positioning recess 121b, the bolt 122 is prevented from falling apart from the hollow pillar 121. Furthermore, before the assembly 10 is assembled to the first object 9, the bolt 122 is fixed in place at the first inserting position because the positioning protrusion 1221 is located in the positioning recess 121b. Because the flexible arms 1211a of the second engaging portion 1212 are not deformed and moved outward at this moment, the first outer diameter W1 of the second engaging portion 1212 is relatively small for the second engaging portion 1212 to be disposed on the first object 9 easily.

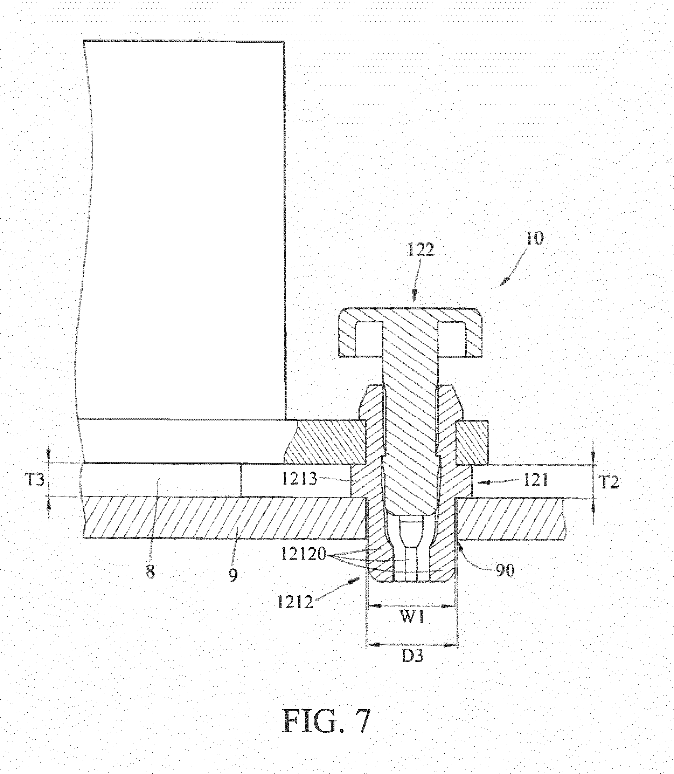

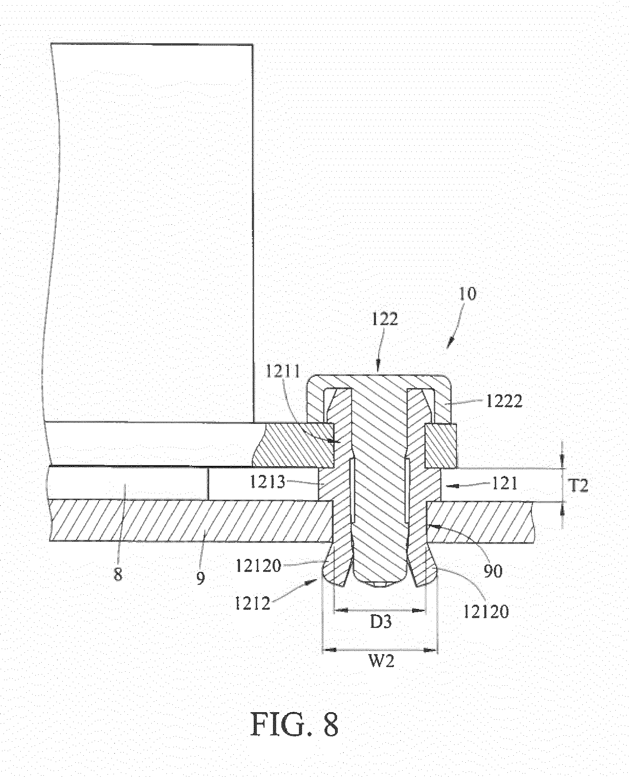

Please refer to FIG. 7 and FIG. 8. FIGS. 7-8 are side views of a process of assembling the assembly to the first object in FIG. 6. As shown in FIG. 7, the bolt 122 is firstly located at the first inserting position, and then the assembly 10 is disposed on the first object 9. Since the flexible arms 1211a of the second engaging portions 1212 of the hollow pillar 121 are not deformed and moved outward at this moment, the first outer diameter W1 of the second engaging portion 1212 is smaller than the inner diameter D3 of first through hole 90 of the first object 9, so that the second engaging portion 1212 is able to be inserted into the first through hole 90 of the first object 9.

Then, as shown in FIG. 8, the bolt 122 is moved to the second inserting position to force the flexible arms 1211a of the second engaging portions 1212 of the hollow pillar 121 to deform and move outward. At this moment, the second engaging portions 1212 press against the inner wall of the first through hole 90 of the first object 9, and the second outer diameter W2 of the second engaging portion 1212 is larger than the inner diameter D3 of the first through hole 90 of the first object 9. In addition, the bearing block 1213 is in contact with the first object 9, and the thickness T2 of the bearing block 1213 is the same as the thickness of the clamped member 8.

Because the second outer diameter W2 of the second engaging portion 1212 is larger than the inner diameter D3 of the first through hole 90 of the first object 9, the second object 11 is firmly fixed on the first object 9 without using any elastic member. Therefore, the second object 11 is prevented from moving with respect to the first object 9 so that the assembly 10 firmly fixed in place.

Furthermore, the bearing block 1213 can keep the second object 11 and the first object 9 to be spaced apart from each other so as to prevent the second object 11 and the first object 9 to press the clamped member 8 and prevent the second object 11 or the first object 9 from being deformed by the second engaging portion 1212. That is, the bearing block 1213 can be taken as a gasket, thus the there is no need to have additional gasket.

Then, the second object 11 and the hollow pillar 121 are two independent objects, so it is favorable to replace the second object 11 according to actual requirements. Furthermore, the hollow pillar 121 is able to be replaced if it is damaged due to friction, so it only needs to replace the damaged component, which is favorable for reducing the cost.

In addition, at this point, the head portion 1222 covers the first engaging portion 1211 of the hollow pillar 121, which makes the appearance simple.

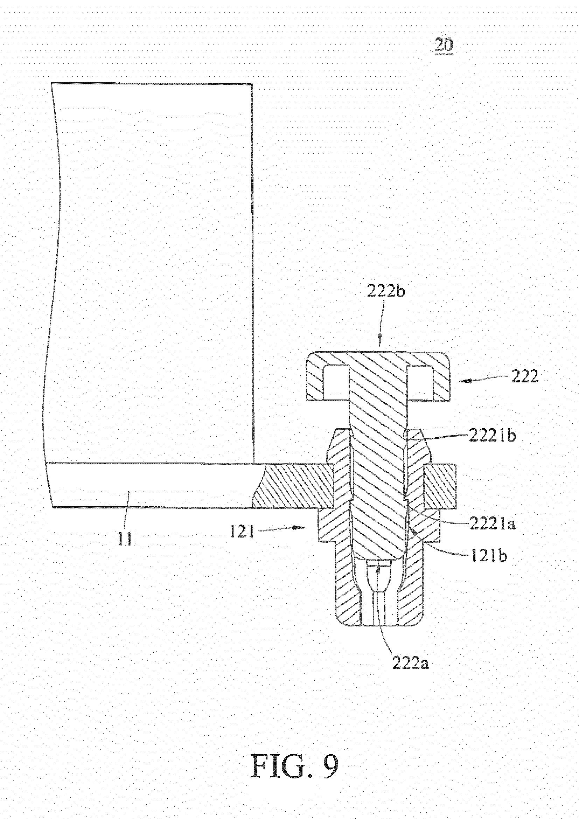

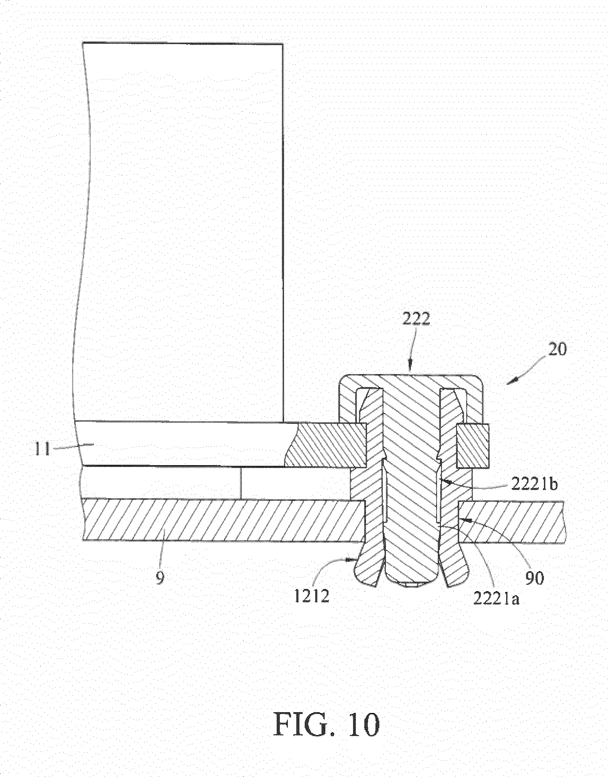

Please refer to FIG. 9 and FIG. 10. FIG. 9 is a side view of an assembly in accordance with an embodiment of the invention. FIG. 10 is a perspective view of the assembly in FIG. 9 being disposed on the first object. The assembly 20 in this embodiment is similar to the assembly 10 in FIG. 5. However, the bolt 222 of the assembly 20 is different from the bolt 122 of the assembly 10 in FIG. 5. The first positioning protrusion 2221a and the second positioning protrusion 2221b are located between the first end 222a and the second end 222b, and the former is closer to the first end 222a, the latter is closer to the second end 222b. As shown in FIG. 9, when the bolt 222 is at the first inserting position, the first positioning protrusion 2221a able to be located in the positioning recess 121b of the hollow pillar 121, and the second positioning protrusion 2221b is able to be removed from the positioning recess 121b.

As shown in FIG. 10, when the second engaging portion 1212 is inserted into the first through hole 90 of the first object 9, and the bolt 222 is moved to the second inserting position. At this moment, the first positioning protrusion 2221a is able to be removed from the positioning recess 121b, and the second engaging portion 1212 is expanded by the bolt 222. The bolt 222 is fixed in place at the second inserting position because the second positioning protrusion 2221b is located in the positioning recess 121b.

According to the latch and the assembly in above examples and embodiments, the first object and the second object are respectively fixed to the first engaging portion and the second engaging portion of the hollow pillar, so the second object is immovable with respect to the first object, thereby the first object and the clamped member between the first object and the second object are prevented from being damaged by the second object. Moreover, the latch and the second object are assembled to be assembly through the first engaging portion. When the bolt is moved to the second inserting position, the second engaging portion is expanded by the bolt. In other words, the size of the second engaging portion becomes larger when the bolt is moved from the first inserting position to the second inserting position. Thus, the second engaging portion of the latch is able to be disposed on the first object easily when the bolt is at the first inserting position, and is able to be fixed to the first object when the bolt is at the second inserting position.

Furthermore, the bearing block can keep the second object and the first object to be spaced apart from each other so as to prevent the second object and the first object to press the clamped member and prevent the second object or the first object from being deformed by the second engaging portion. That is, the bearing block can be taken as a gasket, thus the there is no need to have additional gasket.

In addition, since the positioning protrusion is located in the positioning recess, the bolt is prevented from falling apart from the hollow pillar. Thus the bolt is able to be at the first inserting position or the second inserting position as expected.

Then, the second object and the hollow pillar are two independent objects, so it is favorable to replace the second object according to actual requirements. Furthermore, the hollow pillar is able to be replaced if it is damaged due to friction, so it only needs to replace the damaged component, which is favorable for reducing the cost.

## Claims

1. A latch (12), adapted to fix a first object (9) and a second object (11), and the latch (12) comprising:
a hollow pillar (121), comprising a first engaging portion (1211) and a second engaging portion (1212) opposite to each other, the hollow pillar (121) having an inserting hole (121a) passing through the first engaging portion (1211) and the second engaging portion (1212), and the first engaging portion (1211) configured to be disposed on the second object (11); and
a bolt (122), inserted into the inserting hole (121a) and movable between a first inserting position and a second inserting position; when the bolt (122) is moved from the first inserting position to the second inserting position along a direction from the first engaging portion (1211) pointing to the second engaging portion (1212), and the second engaging portion (1212) is expanded by the bolt (122) in order to be disposed on the first object (9),
wherein the bolt (122) has a head portion (1222) and, when the bolt (122) is at the second inserting position, the head portion (1222) covers at least part of the first engaging portion (1211) of the hollow pillar (121);
wherein the hollow pillar (121) has a positioning recess (121b) at a side close to the inserting hole (121a); the bolt (122) further comprises a first positioning protrusion (2221a) and a second positioning protrusion (2221b); when the bolt (122) is at the first inserting position, the first positioning protrusion (2221a) is located in the positioning recess (121b) and the second positioning protrusion (2221b) of the bolt (222) abuts the first engaging portion (1211); when the bolt (122) is at the second inserting position, the second positioning protrusion (2221b) is located in the positioning recess (121b).

2. The latch (12) according to claim 1, wherein the first engaging portion (1211) comprises a plurality of engaging members (12110) spaced apart from one another, the plurality of engaging members (12110) surround a central axis of the inserting hole (121a), and each of the plurality of engaging members (12110) has an engaging block (1211a) at a side away from the inserting hole (121a).

3. The latch (12) according to claim 2, wherein each of the plurality of engaging blocks (1211a) has a guiding surface (1211b) at the side away from the inserting hole (121a).

4. The latch (12) according to claim 1, wherein the second engaging portion (1212) comprises a plurality of flexible arms (12120) spaced apart from one another, the plurality of flexible arms (12120) surround a central axis of the inserting hole (121a), and each of the plurality of flexible arms (12120) has a pushing block (1212a) at a side close to the inserting hole (121a).

5. The latch (12) according to claim 4, wherein each of the plurality of pushing blocks (1212a) has a guiding surface (1212b) at the side close to the inserting hole (121a).

6. The latch (12) according to claim 1, wherein the hollow pillar (121) further comprises a bearing block (1213), and the first engaging portion (1211) and the second engaging portion (1212) are respectively located at two opposite sides of the bearing block (1213).

7. An assembly (20), adapted to be disposed on a first object (9), and the assembly (20) comprising:
a second object (11), having a through hole (110); and
the latch (12) according to claim 1,
the first engaging portion (1211) disposed through the through hole (110) of the second object (11); and
the bolt (222) disposed through the through hole (110) of the second object (11).

8. The assembly (20) according to claim 7, wherein the first engaging portion (1211) comprises a plurality of engaging members (12110) spaced apart from one another, the plurality of engaging members (12110) surround the central axis of the inserting hole (121a), and each of the plurality of engaging members (12110) has an engaging block (1211a) at a side away from the inserting hole (121a), and the engaging blocks (1211a) are fastened to the second object (11).

9. The assembly (20) according to claim 8, wherein each of the plurality of engaging blocks (1211a) has a guiding surface (1211b) at the side away from the inserting hole (121a).

10. The assembly (20) according to claim 7, wherein the second engaging portion (1212) comprises a plurality of flexible arms (12120) spaced apart from one another, the plurality of flexible arms (12120) surround a central axis of the inserting hole (121a), and each of the plurality of flexible arms (12120) has a pushing block (1212a) at a side close to the inserting hole (121a).

11. The assembly (20) according to claim 10, wherein each of the plurality of pushing blocks (1212a) has a guiding surface (1212b) at the side close to the inserting hole (121a).

12. The assembly (20) according to claim 7, wherein the hollow pillar (121) further comprises a bearing block (1213), the first engaging portion (1211) and the second engaging portion (1212) are respectively located at two opposite sides of the bearing block (1213), and the second object (11) and the first engaging portion (1211) are at the same side of the bearing block (1213).

## Patentansprüche

1. Verriegelung (12), die zum Fixieren eines ersten Objekts (9) und eines zweiten Objekts (11) eingerichtet ist, wobei die Verriegelung (12), umfasst:
eine hohle Säule (121), umfassend einen ersten Eingriffsabschnitt (1211) und einen zweiten gegenüberliegenden Eingriffsabschnitt (1212), wobei die hohle Säule (121) ein Einfügeloch (121a) aufweist, das durch den ersten Eingriffsabschnitt (1211) und den zweiten Eingriffsabschnitt (1212) verläuft, wobei der erste Eingriffsabschnitt (1211) dazu eingerichtet ist, auf dem zweiten Objekt (11) angeordnet zu sein; und
einen Bolzen (122), der in das Einfügeloch (121a) eingefügt und zwischen einer ersten Einfügeposition und einer zweiten Einfügeposition beweglich ist, wenn der Bolzen (122) von der ersten Einfügeposition in die zweite Einfügeposition entlang einer Richtung von dem ersten Eingriffsabschnitt (1211) zu dem zweiten Eingriffsabschnitt (1212) bewegt wird, und der zweite Eingriffsabschnitt (1212) durch den Bolzen (122) geweitet wird, um auf dem ersten Objekt (9) angeordnet zu werden,
wobei der Bolzen (122) einen Kopfabschnitt (1222) aufweist und, wenn sich der Bolzen (122) in der zweiten Einfügeposition befindet, der Kopfabschnitt (1222) wenigstens einen Teil des ersten Eingriffsabschnitts (1211) der hohlen Säule bedeckt (121);
wobei die hohle Säule (121) eine Positionieraussparung (121b) an einer Seite nahe dem Einfügeloch (121a) aufweist; der Bolzen (122) weiterhin einen ersten Positioniervorsprung (2221a) und einen zweiten Positioniervorsprung (2221b) umfasst; wenn sich der Bolzen (122) in der ersten Einfügeposition befindet, sich der erste Positioniervorsprung (2221a) in der Positionieraussparung (121b) befindet und der zweite Positioniervorsprung (2221b) des Bolzens (222) an dem ersten Eingriffsabschnitt (2211) anliegt und wenn sich der Bolzen (122) in der zweiten Einfügeposition befindet, sich der zweite Positioniervorsprung (2221b) in der Positionieraussparung (121b) befindet.

2. Verriegelung (12) nach Anspruch 1, bei der der erste Eingriffsabschnitt (1211) zahlreiche voneinander beabstandete Eingriffselemente (12110) umfasst, wobei die zahlreichen Eingriffselemente (12110) eine Mittelachse des Einfügeloches (121a) umgeben und jedes der zahlreichen Eingriffselemente (12110) einen Eingriffsblock (1211a) an einer Seite hat, die von dem Einfügeloch (121a) entfernt ist.

3. Verriegelung (12) nach Anspruch 2, bei der jeder der zahlreichen Eingriffsblöcke (1211a) eine Führungsfläche (1211b) an der Seite aufweist, die von dem Einfügeloch (121a) abgewandt ist.

4. Verriegelung (12) nach Anspruch 1, bei der der zweite Eingriffsabschnitt (1212) zahlreiche voneinander beabstandete flexible Arme (12120) umfasst, wobei die zahlreichen flexiblen Arme (12120) eine Mittelachse des Einfügeloches (121a) umgeben und jeder der zahlreichen flexiblen Arme (12120) einen Druckblock (1212a) an einer Seite nahe dem Einfügeloch (121a) hat.

5. Verriegelung (12) nach Anspruch 4, bei der jeder der zahlreichen Druckblöcke (1212a) eine Führungsfläche (1212b) an der Seite nahe dem Einfügeloch (121a) aufweist.

6. Verriegelung (12) nach Anspruch 1, bei der die hohle Säule (121) weiterhin einen Lagerblock (1213) umfasst und der erste Eingriffsabschnitt (1211) sowie der zweite Eingriffsabschnitt (1212) jeweils an zwei gegenüberliegenden Seiten des Lagerblocks (1213) angeordnet sind.

7. Baugruppe (20), die zur Anordnung auf einem ersten Objekt (9) eingerichtet ist, wobei die Baugruppe (20) umfasst:
ein zweites Objekt (11) mit einem Durchgangsloch (110); und
die Verriegelung (12) nach Anspruch 1,
den ersten Eingriffsabschnitt (1211), der das Durchgangsloch (110) des zweiten Objekts (11) durchlaufend angeordnet ist; und
den Bolzen (222), der das Durchgangsloch (110) des zweiten Objekts (11) durchlaufend angeordnet ist.

8. Baugruppe (20) nach Anspruch 7, bei der der erste Eingriffsabschnitt (1211) zahlreiche voneinander beabstandete Eingriffselemente (12110) umfasst, wobei die zahlreichen Eingriffselemente (12110) die Mittelachse des Einfügelochs (121a) umgeben und jedes der zahlreichen Eingriffselemente (12110) einen Eingriffsblock (1211a) an einer vom Einfügeloch (121a) abgewandten Seite hat, und die Eingriffsblöcke (1211a) an dem zweiten Objekt (11) befestigt sind.

9. Baugruppe (20) nach Anspruch 8, bei der jeder der zahlreichen Eingriffsblöcke (1211a) eine Führungsfläche (1211b) an der Seite aufweist, die von dem Einfügeloch (121a) abgewandt ist.

10. Baugruppe (20) nach Anspruch 7, bei der der zweite Eingriffsabschnitt (1212) zahlreiche voneinander beabstandete flexible Arme (12120) umfasst, wobei die zahlreichen flexiblen Arme (12120) eine Mittelachse des Einfügelochs (121a) umgeben und jeder der zahlreichen flexiblen Arme (12120) einen Druckblock (1212a) an einer Seite nahe dem Einfügeloch (121a) hat.

11. Baugruppe (20) nach Anspruch 10, bei der jeder der zahlreichen Druckblöcke (1212a) eine Führungsfläche (1212b) an der Seite nahe dem Einfügeloch (121a) aufweist.

12. Baugruppe (20) nach Anspruch 7, bei der die hohle Säule (121) weiterhin einen Lagerblock (1213) umfasst, sich der erste Eingriffsabschnitt (1211) und der zweite Eingriffsabschnitt (1212) jeweils auf zwei gegenüberliegenden Seiten des Lagerblocks (1213) befinden und das zweite Objekt (11) sowie der erste Eingriffsabschnitt (1211) auf derselben Seite des Lagerblocks (1213) sind.

## Revendications

1. Verrou (12), conçu pour fixer un premier objet (9) et un second objet (11), et le verrou (12) comprenant :
un pilier creux (121), comprenant une première partie d'engagement (1211) et une seconde partie d'engagement (1212) opposées l'une à l'autre, le pilier creux (121) ayant un trou d'insertion (121a) passant à travers la première partie d'engagement (1211) et la seconde partie d'engagement (1212), et la première partie d'engagement (1211) étant configurée pour être disposée sur le second objet (11) ; et
un boulon (122), inséré dans le trou d'insertion (121a) et mobile entre une première position d'insertion et une seconde position d'insertion; lorsque le boulon (122) est déplacé de la première position d'insertion vers la seconde position d'insertion le long d'une direction allant de la première partie d'engagement (1211) vers la seconde partie d'engagement (1212), et la seconde partie d'engagement (1212) est élargie par le boulon (122) afin d'être disposée sur le premier objet (9),
dans lequel le boulon (122) a une partie tête (1222) et, lorsque le boulon (122) est à la seconde position d'insertion, la partie tête (1222) couvre au moins une partie de la première partie d'engagement (1211) du pilier creux (121);
dans lequel le pilier creux (121) présente un évidement de positionnement (121b) sur un côté proche du trou d'insertion (121a); le boulon (122) comprend en outre une première saillie de positionnement (2221a) et une seconde saillie de positionnement (2221b); lorsque le boulon (122) se trouve dans la première position d'insertion, la première saillie de positionnement (2221a) est située dans l'évidement de positionnement (121b) et la seconde saillie de positionnement (2221b) du boulon (222) vient en butée contre la première partie d'engagement (1211); lorsque le boulon (122) se trouve dans la seconde position d'insertion, la seconde saillie de positionnement (2221b) est située dans l'évidement de positionnement (121b).

2. Verrou (12) selon la revendication 1, dans lequel la première partie d'engagement (1211) comprend une pluralité d'éléments d'engagement (12110) espacés les uns des autres, la pluralité d'éléments d'engagement (12110) entoure un axe central du trou d'insertion (121a), et chacun de la pluralité d'éléments d'engagement (12110) a un bloc d'engagement (1211a) sur un côté éloigné du trou d'insertion (121a).

3. Verrou (12) selon la revendication 2, dans lequel chacun des blocs d'engagement (1211a) présente une surface de guidage (1211b) sur le côté opposé au trou d'insertion (121a).

4. Verrou (12) selon la revendication 1, dans lequel la seconde partie d'engagement (1212) comprend une pluralité de bras flexibles (12120) espacés les uns des autres, la pluralité de bras flexibles (12120) entoure un axe central du trou d'insertion (121a), et chacun de la pluralité de bras flexibles (12120) a un bloc de poussée (1212a) sur un côté proche du trou d'insertion (121a).

5. Verrou (12) selon la revendication 4, dans lequel chacun de la pluralité de blocs de poussée (1212a) a une surface de guidage (1212b) sur le côté proche du trou d'insertion (121a).

6. Verrou (12) selon la revendication 1, dans lequel le pilier creux (121) comprend en outre un bloc de support (1213), et la première partie d'engagement (1211) et la seconde partie d'engagement (1212) sont respectivement situées sur deux côtés opposés du bloc de support (1213).

7. Ensemble (20), conçu pour être disposé sur un premier objet (9), et l'ensemble (20) comprenant:
un second objet (11), ayant un trou traversant (110); et
le loquet (12) selon la revendication 1,
la première partie d'engagement (1211) disposée à travers le trou traversant (110) du second objet (11); et
le boulon (222) disposé à travers le trou traversant (110) du second objet (11).

8. Ensemble (20) selon la revendication 7, dans lequel la première partie d'engagement (1211) comprend une pluralité d'éléments d'engagement (12110) espacés les uns des autres, la pluralité d'éléments d'engagement (12110) entoure l'axe central du trou d'insertion (121a), et chacun de la pluralité d'éléments d'engagement (12110) a un bloc d'engagement (1211a) sur un côté éloigné du trou d'insertion (121a), et les blocs d'engagement (1211a) sont fixés au second objet (11).

9. Ensemble (20) selon la revendication 8, dans lequel chacun des blocs d'engagement (1211a) présente une surface de guidage (1211b) sur le côté opposé au trou d'insertion (121a).

10. Ensemble (20) selon la revendication 7, dans lequel la second partie d'engagement (1212) comprend une pluralité de bras flexibles (12120) espacés les uns des autres, la pluralité de bras flexibles (12120) entoure un axe central du trou d'insertion (121a), et chacun de la pluralité de bras flexibles (12120) a un bloc de poussée (1212a) sur un côté proche du trou d'insertion (121a).

11. Ensemble (20) selon la revendication 10, dans lequel chacun des blocs de poussée (1212a) possède une surface de guidage (1212b) sur le côté proche du trou d'insertion (121a).

12. Ensemble (20) selon la revendication 7, dans lequel le pilier creux (121) comprend en outre:
un bloc de roulement (1213), la première partie d'engagement (1211) et la seconde partie d'engagement (1212) sont respectivement situées sur deux côtés opposés du bloc de roulement (1213), et le second objet (11) et la première partie d'engagement (1211) sont du même côté du bloc de roulement (1213).
